**Europäisches Patentamt**

(19) **European Patent Office**

**Office européen des brevets**

(11) Publication number: **0 163 138**
**A1**

(12) # EUROPEAN PATENT APPLICATION

(21) Application number: **85105082.3**

(51) Int. Cl.⁴: **H 03 K 17/96**

(22) Date of filing: **26.04.85**

(30) Priority: **21.05.84 US 612628**

(43) Date of publication of application:
**04.12.85 Bulletin 85/49**

(84) Designated Contracting States:
**AT BE CH DE FR GB IT LI LU NL SE**

(71) Applicant: **ENERGY CONVERSION DEVICES, INC.**
**1675 West Maple Road**
**Troy Michigan 48084(US)**

(72) Inventor: **Yaniv, Zvi**
**27610 Arlington Court**
**Southfield michigan 48076(US)**

(72) Inventor: **Canella, Vincent D.**
**18625 Devonshire**
**Birmingham Michigan 48009(US)**

(74) Representative: **Müller, Hans-Jürgen, Dipl.-Ing. et al,**
**Müller, Schupfner & Gauger Lucile-Grahn-Strasse 38**
**Postfach 80 13 69**
**D-8000 München 80(DE)**

(54) **Touch sensitive keyboard input device and method.**

(57) There is disclosed a device and method for providing keyboard input signals. The device includes a plurality of spaced apart photosensors (16) having light sensitive elements formed from deposited semiconductor material. Each of the elements is capable of effecting a change in a detectable electrical characteristic in response to a change in the light incident on the element. The incident light is changed by substantially blocking the light incident on a selected photosensor (16) to provide a keyboard input signal representative of that photosensor (16).

FIG 2

# TOUCH SENSITIVE KEYBOARD INPUT DEVICE AND METHOD

## FIELD OF THE INVENTION

The present invention generally relates to a device and method for providing keyboard input signals. The present invention particularly relates to a touch sensitive device and method for providing signals in response to changes in light incident on selected photosensors.

## BACKGROUND OF THE INVENTION

Keyboard input systems are well known and are utilized for numerous applications, such as calculators, telephones, typewriters, computers and numerous other alphanumeric input uses. Such prior art keyboards have typically been mechanical, requiring mechanical moving parts and electrical contacts which tend to fail due to misalignment or

-2-

fatigue. Mechanical keyboards are separate units from the electrical and electronic circuitry and have to be separately connected. The separate keyboards and connections all result in additional parts and assembly steps. In addition, mechanical keyboards are often heavy and bulky in size. Thus it can be seen that prior keyboard systems are not as small in size, light in weight and durable as is desired for the increased use of keyboard systems, especially in portable applications.

## SUMMARY OF THE INVENTION

The invention therefore provides a new and improved touch sensitive device and method for providing keyboard input signals which is integral with the electronic circuitry. The invention, in accordance with one embodiment, includes a plurality of photosensors having light sensitive elements which are spaced far enough apart to enable a human finger to selectively block light from an individual one of such photosensors. The elements effect a change in a detectable electrical characteristic in response to a change in the light incident on the element, which change is sensed to provide the keyboard signals.

The present invention more particularly provides a touch sensitive device including a plurality of photosensors having light sensitive elements which are coupled to sensor circuitry which senses the electrical characteristics of each of the light sensitive elements. A keyboard input signal generator is coupled to the sensor circuitry to generate a signal whan a change in the electrical characteristic of one of the elements is sensed.

The device can include a display to display the generated signals. The sensor circuitry can include a comparator for generating a signal only when a threshold level is exceeded. The device can include a discriminator to allow a signal to be generated when only one light sensitive element has a changed electrical characteristic.

The light sensitive elements can be photovoltaic cells or photoresistors. The elements can be formed from deposited semiconductor material, preferably an amorphous semiconductor alloy. In one embodiment a plurality of elements are formed of a unitary body of light sensitive material with the individual photosensors being defined by individual conductors making electrical contact to the unitary body at separate locations.

The present invention further provides a method of generating keyboard signals. The method includes providing a plurality of the light sensitive elements, changing the light incident on a selected one of the elements to change its electrical characteristic, sensing the changed characteristic and generating an input signal in response to the changed characteristic. The signal can be displayed and can be generated when only one changed characteristic is sensed.

## BRIEF DESCRIPTION OF THE DRAWINGS

Fig. 1 is a partial cross-sectional side view of a touch sensitive keyboard input device embodying the present invention;

Fig. 2 is a schematic block diagram of one embodiment of the input device of Fig. 1;

Fig. 3 is a partial cross-sectional side view illustrating one embodiment of a light sensitive element embodying the invention;

Fig. 4 is a partial schematic block diagram of a plurality of the elements of Fig. 3;

Fig. 5A is a partial cross-sectional side view illustrating another embodiment of a light sensitive element embodying the invention;

Fig. 5B is a partial cross-sectional side view illustrating a further embodiment of a light sensitive element embodying the invention; and

Fig. 6 is a partial schematic block diagram of a plurality of the elements of Figs. 5A or 5B.

## DESCRIPTION OF THE PREFERRED EMBODIMENTS

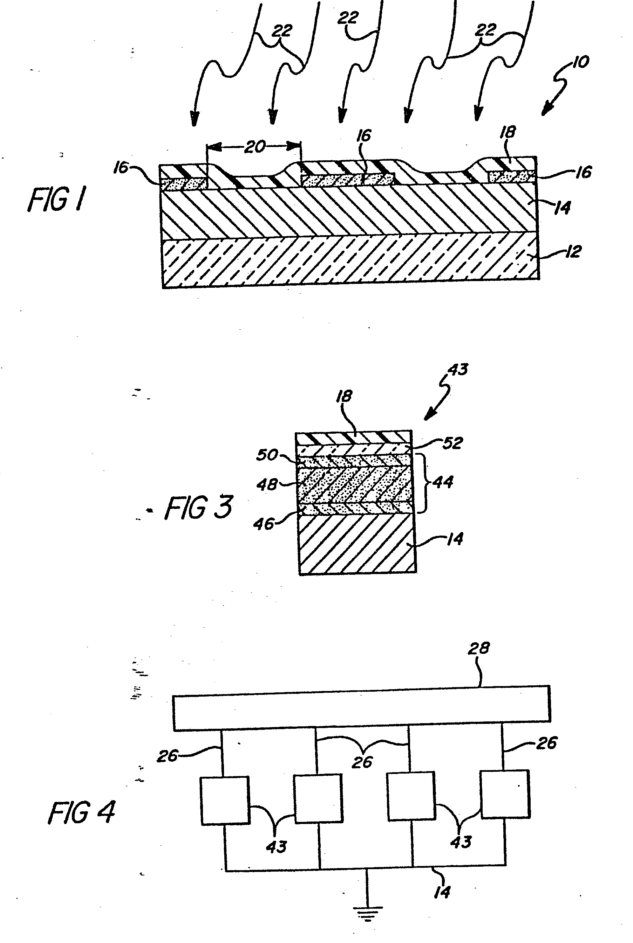

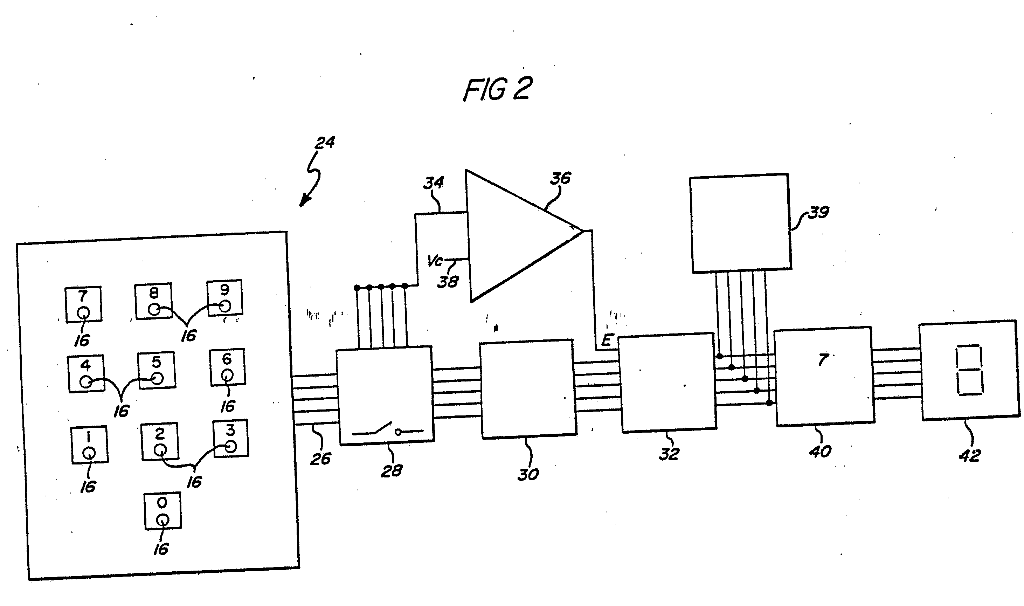

Fig. 1 illustrates a touch sensitive keyboard input device 10 embodying the present invention. The device 10 includes a substrate 12, which can be formed from any convenient generally insulative material. A common electrode or line 14 is formed on the substrate 12. A plurality of photosensors 16 are formed on the common electrode 14. A transparent covering 18 is formed over the photosensors 16, which covering can be a polymer material.

The photosensors 16 are distributed over the electrode 14 in spaced apart relation to form spaces 20 between the photosensors. The photosensors 16 include light sensitive elements which effect a detectable electrical characteristic in response to a change in light incident thereon. As will be more fully described hereinafter, the light sensitive elements of the photosensors 16 can be photovoltaic cells or photoresistors.

The light sensitive elements are preferably formed from a deposited semiconductor material, such as, an amorphous semiconductor alloy. Preferably, the amorphous semiconductor alloy includes silicon and hydrogen, silicon and fluorine or silicon, fluorine and hydrogen. Such alloys can be deposited by plasma-assisted chemical vapor deposition, i.e., glow discharge, as disclosed, for example, in U.S. Patent No. 4,226,898 which issued on October 7, 1980 in the names of Stanford R. Ovshinsky and Arun Madan for Amorphous Semiconductors Equivalent To Crystalline Semiconductors Produced By A Glow Discharge Process.

Ambient light 22 incident upon the device 10, passes through the cover 18 to impinge on the photosensors 16. The photosensors 16 include the light sensitive elements which effect a detectable change in an electrical characteristic in relation to the intensity of light impinging on the photosensors 16. The light sensitive elements of the photosensors 16 can be formed from photovoltaic cells which will effect a change in electrical conductivity and will generate current and voltage in response to incident light. The light sensitive elements can also be formed from photoresistors which will effect a change in electrical conductivity as the intensity of the incident light changes.

The incident light can be changed by placing a finger, stylus or other relatively opaque object on or closely adjacent the cover 18 above a photosensor 16 which is selected for the input. By blocking or substantially blocking the light incident on the selected photosensor 16, a change in the electrical characteristic of the photosensor is effected which can then be sensed to provide the keyboard input signal. The spaces 20 are configured to allow one photosensor 16 to be selected at a time.

Fig. 2 illustrates one embodiment of a keyboard 24 embodying the present invention. The keyboard 24 includes ten of the photosensors 16, each associated with a numerical digit to be input as part of a calculator or other type of keyboard input device, not illustrated. The photosensors 16 illustrated, are merely for example, and can be any number and type of alpha/numeric or control input keys in any desired configuration.

Preferably, as described with respect to Fig. 1, the photosensors 16 are connected in parallel such as by the electrode 14 and the electrical characteristic is then read off a second individual line 26. The lines 26 are coupled to a switch 28, such as an analog switch, which senses the electrical characteristic of each of the photosensors 16 in sequence. The switch 28 couples the input key identity to a decoder 30, which in turn couples the identity to a memory element or latch 32.

The switch 28 also couples the sensed electrical characteristic to one input 34 of a comparator 36. A second comparator input 38 has as an input a threshold voltage level V. The threshold level V is selected to trigger the comparator 36 when the analog signal from one of the key photosensors 16 falls below the threshold level. The latch 32 retains the signal coupled to it from the comparator 36 and the identity of the key coupled to it from the decoder. The latch 32 further is configured to generate an output signal when only one of the photosensors 16 is being keyed. If two or more of the key elements have triggered the comparator 36, then the latch 32 will not provide an output signal.

The switch 28, decoder 30, latch 32 and the comparator 36 form the sensor circuitry for the keyboard device. The particular elements shown in the embodiment can be changed in numerous ways, so long as the sensing functions enumerated are maintained. When a valid key input signal is determined by the sensor circuitry, it is coupled to appropriate logic circuitry 39. The signal can also be coupled to a display driver 40 which in turn is coupled to a digital display 42. Although not illustrated, any number of digits can be entered in sequence, can be displayed and can be kept in memory, for example as in a conventional calculator operation.

Referring to Fig. 3, one embodiment of the light sensitive element of the photosensor 16, a photovoltaic cell 43 is best illustrated. The element 43 is formed on the electrode 14 and can include an amorphous silicon alloy body 44 having a first doped region 46, an intrinsic region 48 and a second doped region 50. The regions 46 and 50 are preferably opposite in conductivity and the region 46 can be p-type with the region 50 being n-type. Overlying the n-type region 50 is a layer of a transparent conductor 52 which has the protective cover 18 thereover.

The type of photovoltaic cell or photodiode is not critical and can include cells of inverse orientations, p-n junction and Schottky type cells among others. Cells of these types are fully disclosed, for example, in the aforementioned U.S. Patent No. 4,226,898 and therefore are not described in detail herein. The cells preferably are formed from a deposited amorphous silicon alloy which includes hydrogen, hydrogen and/or fluorine.

The photovoltaic cell elements 43 can be connected in parallel as illustrated in Fig. 4. The common electrode 14 can be at ground potential and the switch 28 is coupled by the lines 26 to the conductor 52 of each element 43. The sensor circuitry thus directly senses the output voltages of the photovoltaic elements 43 through the switch 28, which varies as the incident light changes. The elements 43 can be individually formed on the electrode 14 or can be formed as a unitary alloy body 44 with the elements 43 being defined by separate regions of the conductor 52.

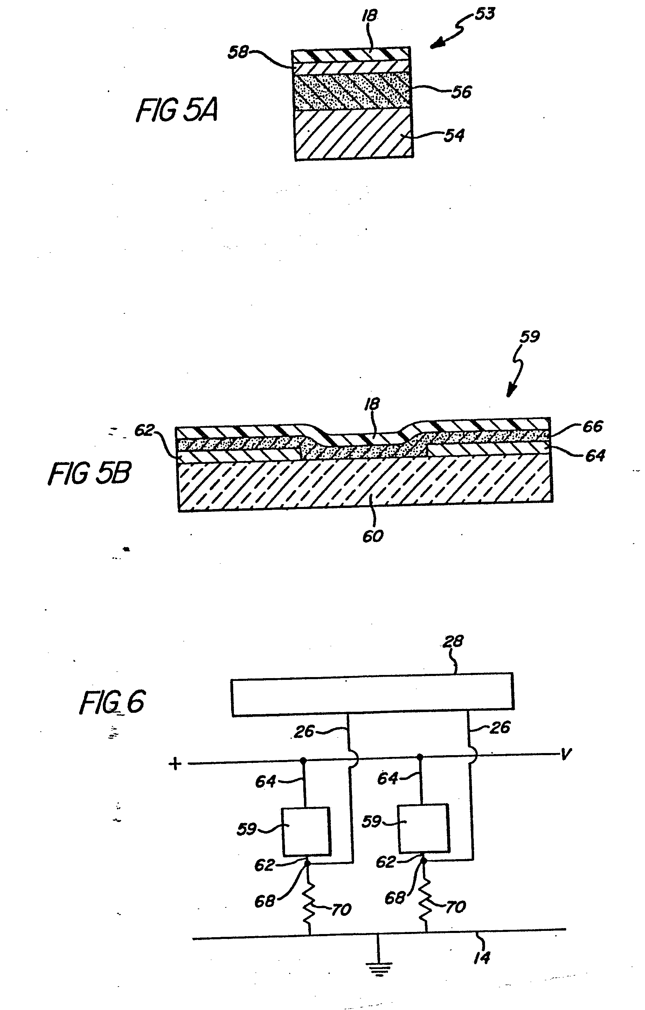

A second embodiment of the light sensitive element of the photosensors 16, a photoresistor is best illustrated in Figs. 5A and 5B. Fig. 5A illustrates a vertical construction type of photoresistor 53. The photoresistor 53 is formed with a metal layer 54 upon which is formed a substantially intrinsic body of amorphous silicon alloy 56. A transparent conductive layer 58 is formed on the alloy body 56. If desired, an n-type amorphous silicon alloy layer (not illustrated) can be formed between the body 56 and the layer 54 to improve the ohmic contact between the body 56 and the conductor 54. The conductor 58 again is followed by the cover 18.

Another photoresistor embodiment 59, of the light sensitive element of the photosensor 16 is illustrated in Fig. 5B. The photoresistor 59 is formed in a planar configuration on an insulative substrate 60. A pair of leads 62 and 64 are formed on the substrate 60 and a body of amorphous silicon alloy 66 is formed over the leads 62 and 64 and the substrate 60. The cover 18 is formed over the alloy body 66.

The photoresistor elements 53 and 59 can be coupled in parallel as described with respect to the element 59 in Fig. 6. The leads 64 can be coupled to a bias voltage V BIAS and the leads 62 are each connected to a junction 68 between a resistor 70 and the sensing line 26. The switch 28 senses the potential developed between the ground line 14 and the junction 68 on the line 26. In the dark, the photoresistor 59 will have a high resistance which can be chosen to be equal to the resistance of the resistor 70. In the light, the photoresistor 59 increases its electrical conductivity, such that its resistance can be less than one-tenth of its dark resistance. Therefore, when the light is blocked from a photoresistor 59, the potential across the resistor 70 at the junction 68 will almost decrease by one-half which is easily sensed by the sensor circuitry through the switch 28.

Again, the photoresistors 53 can be formed as an integral body 56 over the electrode 54, with the photoresistors 53 being defined by separated individual portions of the conductor 58. Further, the photosensors 16 and the sensor circuitry can be formed on the same substrate at the same time as the logic circuitry 39, hence forming the keyboard input device 10 integrally with the logic circuitry.

From the foregoing, it can be appreciated that the present invention provides a new and improved touch sensitive device for providing keyboard input signals. The light sensitive elements of the photosensors can be formed from photovoltaic cells or photoresistors which exhibit a detectable change in an electrical characteristic upon a change in the incident light. The integral keyboard input device of the present invention exhibits distinct advantages over prior keyboard systems. The device can be made very small in size, light in weight and has no moving parts which are subject to wear and servicing.

Modifications and variations of the present invention are possible in light of the above teachings. The photosensors do not have to be coupled in parallel, but can be separately connected if desired. The cover can be any type of transparent covering, such as glass. The photosensors can be arranged to have more than one keyed simultaneously, if desired. It is therefore to be understood that

-10-

within the scope of the appended claims the invention
may be practiced otherwise than as specifically
described.

-11-

## CLAIMS

1. An input device of the type comprising a plurality of photosensors (16;43;53;59), each photosensor including light sensitive means (16;43;53;59) for effecting a detectable change in an electrical characteristic in response to incident light, and means (28) coupled to said light sensitive means for sensing the electrical characteristic of each of said light sensitive means; said input device being characterized by being a touch sensitive keyboard which includes means (30,32,36) coupled to said sensing means for generating a keyboard input signal when a change is sensed in the electrical characteristic of a selected one of said light sensitive means.

2. The device as defined in claim 1 further characterized by including means (32,36) for generating said keyboard signal when only one of said light sensitive means (16;43;53;59) has a changed electrical characteristic.

3. The device as defined in claim 1 further characterized by including logic means (39) for utilizing said input signal generated by said signal generating means (30,32,36), and further characterized by said light sensitive means (16;43;53;59), said sensing means (28), said signal generating means (30,32,36), and said logic means (39) being formed integrally with one another.

4. The device as defined in claim 1 further characterized by said light sensitive means (16) including photovoltaic cells (43).

5. The device as defined in claim 2 further characterized by said light sensitive means (16) including photoresistors (53,59).

-12-

6. The device as defined in claim 1 further characterized by said light sensitive means (16;43;53;59) being formed from deposited semiconductor material (44;56,66).

7. The device as defined in claim 6 further characterized by said deposited semiconductor material (44;56,66) being an amorphous semiconductor alloy.

8. The device as defined in claim 7 further characterized by said amorphous semiconductor alloy (44;56,66) including silicon.

9. The device as defined in claim 8 further characterized by said amorphous semiconductor alloy (44;56,66) further including hydrogen.

10. The device as defined in claim 8 further characterized by said amorphous semiconductor alloy (44;56,66) further including fluorine.

11. The device as defined in claim 7 further characterized by said light sensitive means (16) including photovoltaic cells (43) having a first doped region (46), a substantially intrinsic region (48), and a second doped region (50) of opposite conductivity with respect to said first doped region.

12. The device as defined in claim 6 further characterized by said photosensors (16) being photovoltaic cells (43) formed of deposited semiconductor material (44) on a common substrate (12).

13. The device as defined in claim 12 further characterized by a given plurality of said photovoltaic cells (43) being formed of material (44) deposited on a common conductor (14) to which they are electrically connected in common and by each of said given plurality of cells being connected to a separate top conductor (26,52).

14. The device as defined in claim 13 further characterized by said given plurality of photovoltaic cells (43) being formed of at least one unitary body (44,46,48,50) of deposited semiconductor material and by the individual members (43) of said plurality of photovoltaic cells being defined by separate top conductors (26,52).

15. The device as defined in claim 1 further characterized by each of a given plurality of said photosensor (16) having an alphanumeric symbol or control function associated with it, by an individual one of said photosensors (16) and each of its adjacent photosensors (16) having a different alphanumeric symbol or control function associated with it and by said means (30,32,36) for generating a keyboard input signal including means (30) for generating a signal representing the different alphanumeric signal or control function associated with each individual one of said adjacent photosensors (16) when a change is sensed in the electrical characteristic of its light sensitive means.

16. The devices as defined in claim 1 further characterized by said photosensor (16;43;53;59) being spaced apart sufficiently to enable said photosensors to be individually selectable by a human finger.

17. The device as defined in claim 1 further characterized by a given plurality of said photosensor (16;43;53;59) being formed of at least one unitary body (44,46,48,50;56;66) of deposited semiconductor material and by the individual members (16;43;53;59) of said plurality of photosensors being defined by separate conductors (26;52;58) in electrical contact with separate portions of said unitary body.

18. A method of generating an input signal of the type comprising providing a plurality of photosensors (16;43;53;59), each photosensor including light sensitive means (16;43;53;59) for effecting a detectable change in an electrical characteristic in response to incident light, changing the amount of light incident upon a selected one of said light sensitive means to change the electrical characteristic thereof, and sensing said change in the electrical characteristic, said method being characterized by the use of photosensors as a keyboard (10;24) and by generating a keyboard input signal in response to sensing a change in the electrical characteristic of said one selected light sensitive means.

19. The method as defined in claim 18 further characterized by the changing of said incident light including substantially blocking the light received by said one selected light sensitive means (16;43;53;59).

20. The method as defined in claim 19 further characterized by the use of a human finger to block the light received by said one selected light sensitive means (16;43;53;59).

21. The method as defined in claim 18 further characterized by said photosensors (16;43) being photovoltaic cells 43 and by said change in the electrical characteristic which is sensed being a change in the photovoltaic potential generated by a selected photovoltaic cell.

0163138

FIG 1

FIG 3

FIG 4

FIG 2

*FIG 5A*

18
53
58
56
54

*FIG 5B*

59
18
62
66
64
60

*FIG 6*

28
26
26
V
+
64
64
59
59
62
62
68
70
68
70
14

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | EP-A-0 064 025 (ASULAB S.A.)<br><br>* Figures 1-5; figure 6, elements 110-116, 600-605, 639; 624-627; figure 9; page 4, line 14 - page 24, line 21 *<br><br>--- | 1,15, 16,18-20 | H 03 K 17/96 |
| X | US-A-4 329 581 (R.C. HELFRICH, JR., et al.)<br><br>* Figures 1,2; column 2, line 33 - column 3, line 58 *<br><br>--- | 1,15, 16,28-20 | |
| A | INTEL COMPONENT DATA CATALOG, 1979, pages 8-10 - 8-21<br>* Pages 8-17, 8-18<br><br>--- | 1 | |
| A | (A. BORGNA)<br>* Figure 1; claim 1 *<br><br>--- | 1 | **TECHNICAL FIELDS SEARCHED (Int. Cl.4)**<br><br>G 06 F 3/02<br>G 06 F 3/023 |
| A | (R.E. WATSON)<br>* Figure; abstract *<br><br>--- | 2 | G 06 K 11/06<br>H 01 L 31/02<br>H 01 L 31/08<br>H 03 K 13/24 |
| A | (HITACHI LTD.)<br>* Figure 1; page 1, lines 52-75 *<br><br>--- | 2 | H 03 K 17/94<br>H 03 K 17/96 |
| A | (Y. IWAI et al.)<br>* Figure 9a, element 51 *<br><br>--- -/- | 2 | |

The present search report has been drawn up for all claims

| Place of search | Date of completion of the search | Examiner |
|---|---|---|
| BERLIN | 10-07-1985 | ARENDT M |

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | (B.D. HUNTS et al.)<br>* Figure 5; column 6, lines 52-68 *<br><br>--- | 2 | |
| D,A | (S.R. OVSHINSKY et al.)<br>* Figure 7; column 7, lines 9-32; column 17, line 59 - column 18, line 11 *<br><br>--- | 4,6-11 | |
| A | (S. ISHIHARA et al.)<br>* Figure 2; abstract *<br><br>----- | 5 | |

TECHNICAL FIELDS
SEARCHED (Int. Cl.4)

The present search report has been drawn up for all claims

| Place of search | Date of completion of the search | Examiner |
|---|---|---|
| BERLIN | 10-07-1985 | ARENDT M |